# EUROPEAN PATENT APPLICATION

(11) **EP 3 833 009 A1**
(43) Date of publication of application: **09.06.2021**
(21) Application number: 19845212.0
(22) Date of filing: 28.06.2019
(51) Int. Cl.: H04N 5/64, H01L 23/36, H01M 2/10, H01M 10/613, H01M 10/62, H01M 10/651, H01M 10/653, H01M 10/6554, H05K 7/20

(54) **DISPLAY DEVICE AND METHOD FOR RADIATING HEAT**

(30) Priority: 30.07.2018 JP 2018142835
(71) Applicant: Sony Corporation, 108-0075 Tokyo (JP)
(72) Inventor: YAMADA, Hiroto, Tokyo 108-0075 (JP)
(74) Representative: MFG Patentanwälte Meyer-Wildhagen Meggle-Freund Gerhard PartG mbB
(86) International application number: PCT/JP2019/025784
(87) International publication number: WO 2020/026661

(57) **Abstract**

A display device according to the present disclosure includes a second member (220) that is attachable to a first member (210) including a high-temperature part. The second member includes a first heat-transfer member (230) that is deformable and partially contactable with the high-temperature part and an elastic body (240) that allows the first heat-transfer member to abut on the high-temperature part.

## Description

### Technical Field

The present disclosure relates to a display device and a heat release method.

### Background Art

In general, an electronic component, a light-emitting element, or the like installed in a display device produces heat during operation. Therefore, the display device is required to efficiently release the heat produced by the electronic component, the light-emitting element, or the like in the display device. For example, PTL 1 listed below discloses a technology of releasing heat produced by a high-temperature part to an outside via a heat-transfer member partially fixed to the high-temperature part.

### Citation List

### Patent Literature

PTL 1: WO 2015/083316

### Summary of the Invention

### Problems to be Solved by the Invention

However, for example, according to the technology disclosed in PTL 1, the heat-transfer member is bonded to the high-temperature part with adhesive. Therefore, for example, in a case where the high-temperature part deforms over time like a battery, tensile strength is generated between the adhesive and the high-temperature part due to a difference in thermal expansion between the adhesive and the high-temperature part. This may result in separation of the heat-transfer member from the high-temperature part. As a result, there is a possibility that it becomes difficult for the heat-transfer member to release heat produced by the high-temperature part to the outside. As described above, it has been desired to further improve performance of the display device including a mechanism for releasing heat produced by the high-temperature part to the outside.

Accordingly, the present disclosure proposes a display device and heat release method that make it possible to release heat to an outside more stably.

### Means for Solving the Problem

According to the present disclosure, there is provided a display device including a second member that is attachable to a first member including a high-temperature part. The second member includes: a first heat-transfer member that is deformable and partially contactable with the high-temperature part; and an elastic body that allows the first heat-transfer member to abut on the high-temperature part.

In addition, according to the present disclosure, there is provided a heat release method including: installing a second member that is attachable to a first member including a high-temperature part; installing, in the second member, a first heat-transfer member that is deformable and partially contactable with the high-temperature part, and an elastic body that allows the first heat-transfer member to abut on the high-temperature part; and releasing heat of the high-temperature part to an outside.

According to the present disclosure, the deformable first heat-transfer member, which is included in the second member that is attachable to a first member including the high-temperature part, comes into contact with the high-temperature part. The elastic body allows the first heat-transfer member to abut on the high-temperature part by using its elastic force. This allows the first heat-transfer member to follow deformation of the high-temperature part while maintaining contact with the high-temperature part even in a case where the high-temperature part deforms over time.

### Effect of the Invention

As described above, according to the present disclosure, it is possible to release heat to an outside more stably.

It is to be noted that the above-described effects are not necessarily limitative. In addition to or in place of the above effects, there may be achieved any of the effects described in the present specification or other effects that may be grasped from the present specification.

### Brief Description of the Drawings

[FIG. 1] FIG. 1 is an overall view of a display device according to an embodiment of the present disclosure.
[FIG. 2] FIG. 2 is a schematic diagram illustrating a state where a first member and a second member of a rear block according to the embodiment are separated from each other.
[FIG. 3] FIG. 3 is a plan view illustrating a schematic internal configuration of the rear block of the display device according to the embodiment.
[FIG. 4] FIG. 4 is an explanatory diagram for describing arrangement of a first heat-transfer member and an elastic body before and after deformation of a high-temperature part according to the embodiment.
[FIG. 5] FIG. 5 is a cross-sectional view illustrating a schematic internal configuration of the rear block of the display device according to the embodiment.
[FIG. 6] FIG. 6 is a cross-sectional view illustrating a schematic internal configuration of a rear block of a display device according to another mode of the embodiment.

### Modes for Carrying Out the Invention

Hereinafter, preferred embodiments of the present invention are described in detail with reference to the appended drawings. It is to be noted that, in the present specification and drawings, repeated description is omitted for components substantially having the same functional configuration by assigning the same reference numerals.

It is to be noted that, the description is given in the following order.
<1. Background>
<2. Embodiment>
<3. Conclusion>

### <1. Background>

With regard to existing heat release structures installed in a variety of display devices, a high-temperature part and a heat-transfer member are coupled to each other in a fixed state. For example, in many case, a structure in which a heat sink (heat spreader) made of aluminum or copper is fixed to the high-temperature part has been adopted. When the heat sink is adopted as the heat release structure, the weight of the display device has been increased and the number of components has been increased due to the heat sink in many cases. In addition, designs of the display devices have been limited because a space for installing the heat sink should have been ensured in the display device. In addition, for example, when the aluminum heat sink, which has often been used in general, is adopted as head-mounted products, the weight of the head-mounted products increases and wearability is deteriorated. Therefore, technologies of releasing heat of the high-temperature part without adopting the heat sink have been under development. For example, the above-exemplified PTL 1 discloses the display device including a deformable heat-transfer member attached to the heat-transfer member and a casing. However, for example, in a case where the high-temperature part such as a battery deforms over time, there is a possibility that the heat-transfer member of such a display device separates from the high-temperature part and it becomes difficult for the heat-transfer member to release heat of the high-temperature part to an outside. Accordingly, the inventors of the present disclosure diligently researched such a possibility, and invented the present technology.

### <2. Embodiment>

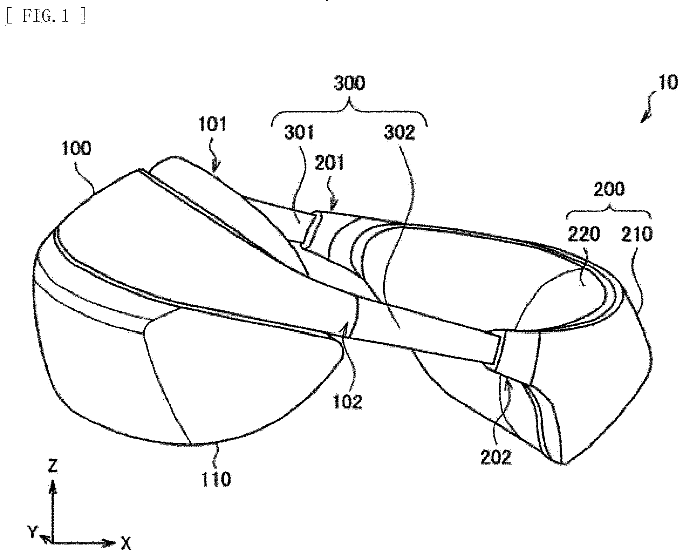

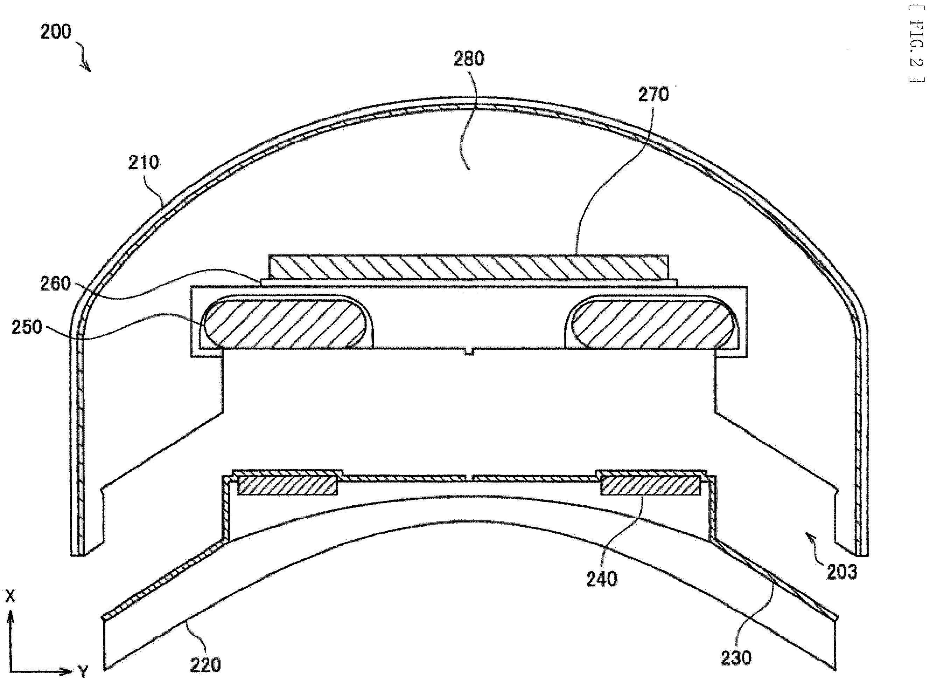

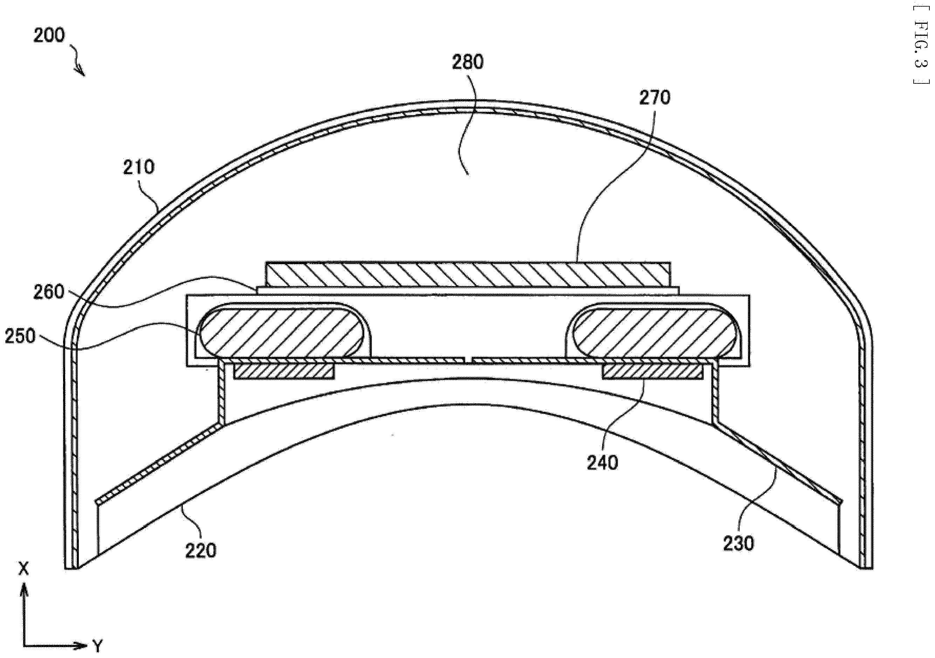

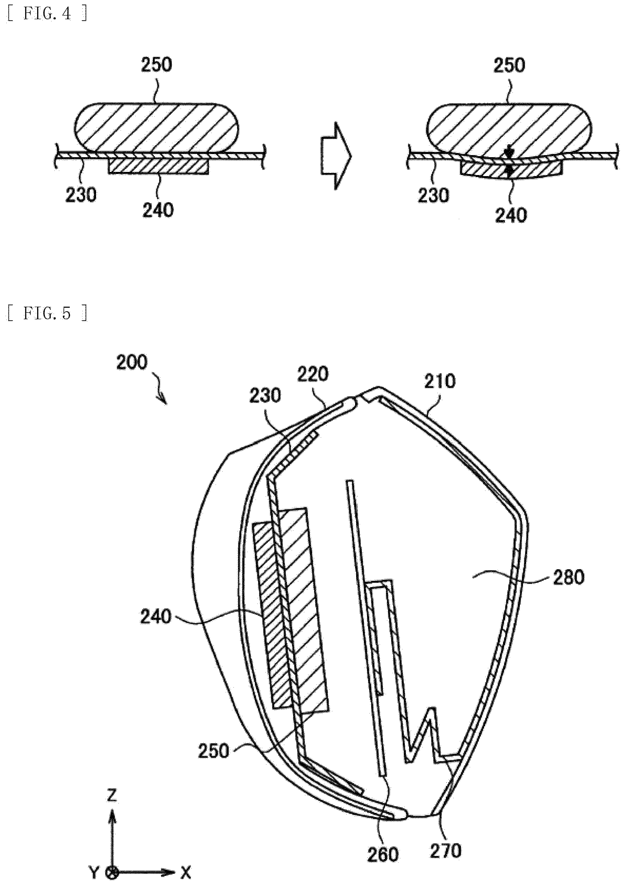

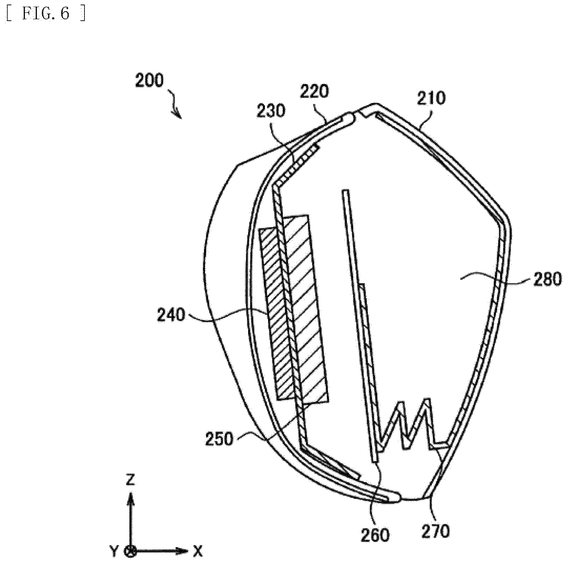

A display device according to the present embodiment includes a second member attachable to a first member including a high-temperature part. The second member includes a first heat-transfer member and an elastic body. The first heat-transfer member is deformable and at least partially contactable with the high-temperature part. The elastic body allows the first heat-transfer member to abut on the high-temperature part. The elastic body allows the first heat-transfer member to abut on the high-temperature part while the second member is attached to the first member, for example. In the present embodiment, the wording "abut" means that at least a portion of an object is in contact with at least a portion of another object. In other words, the elastic body allows at least a portion of the first heat-transfer member to come into contact with at least a portion of the high-temperature part. The display device according to the present embodiment may be implemented as a variety of stationary display devices (such as a stationary liquid crystal display device or a stationary organic EL display device, for example) or a wearable display such as a head-mounted display (HMD), for example. Next, with reference to FIG. 1 to FIG. 6, the display device according to the present embodiment is described while the HMD is used as an example. FIG. 1 is an overall view of a display device 10 according to the present embodiment. FIG. 2 is a schematic diagram illustrating a plan view of a schematic internal configuration of a rear block 200 of the display device 10 in a state where a first member 210 and a second member 220 are separated. FIG. 3 is a plan view illustrating a schematic internal configuration of the rear block 200 of the display device 10. It is to be noted that FIG. 2 and FIG. 3 illustrate a cross-section of a central portion of the rear block 200 in a Z-axis direction illustrated in FIG. 1. The cross-section is taken in parallel to an XY-plane. FIG. 4 is an explanatory diagram for describing arrangement of a first heat-transfer member 230 and an elastic body 240 before and after deformation of the high-temperature part. FIG. 5 is a plan view illustrating a schematic internal configuration of the rear block 200 of the display device 10. FIG. 6 is a cross-sectional view illustrating a schematic internal configuration of a rear block of a display device 10 according to another mode. It is to be noted that FIG. 5 and FIG. 6 illustrate cross-sections of central portions of the rear blocks 200 in a Y-axis direction illustrated in FIG. 1. The cross-sections are taken in parallel to a ZX-plane.

The HMD, which serves as an example of the display device 10 according to the present embodiment, includes a front block 100, the rear block 200, and couplers 300. The display device 10 is worn on the head of a user such that the front block 100, the rear block 200, and the couplers 300 surround the head of the user.

It is to be noted that, in the following description, a direction in which the front block 100 and the rear block 200 are disposed in the head-mounted display 10 with the head of the user is interposed therebetween is referred to as an X-axis direction. Here, a direction from the front block 100 to the rear block 200 along the X-axis direction is deemed to be a positive direction of the X axis. In addition, two directions orthogonal to each other in a plane perpendicular to the X-axis direction are respectively referred to as the Y-axis direction and the Z-axis direction. In this case, the Z-axis direction is a direction corresponding to the height of the user.

The front block 100 includes a display unit 110 and has a function of providing the user with a variety of images. The display unit 110 is disposed in front of the eyes of the user when the display device 10 is worn by the user. The display unit 110 of the front block 100 may be a transparent display or a non-transparent display. The transparent display does not block a field of view of the user in a state where no image is displayed. In addition, the display unit 110 may be disposed in front of both of the eyes of the user or one of the eyes of the user. The front block 100 may include a camera (not illustrated) for capturing an image of the field of view of the user corresponding to a direction of the face of the user wearing the HMD.

As illustrated in FIG. 1, the couplers 300 are respectively coupled to a first side end 101 and a second side end 102 of the front block 100. The first side end 101 is one of the side ends of the front block 100. The second side end 102 is the other side end of the front block 100 positioned on an opposite side from the first side end 101 in the Y-axis direction.

The couplers 300 have a function of coupling the front block 100 to the rear block 200. Examples of material for the couplers 300 may include metal material, resin material, and the like. For example, aluminum alloy, titanium alloy, stainless steel, acetylcellulose, a polyamide, or the like may be used.

The couplers 300 extend in a rear direction respectively from the first side end 101 of the front block 100 and the second side end 102 of the front block 100 positioned on the opposite side from the first side end 101 in the Y-axis direction. A coupler 301 extending from the first side end 101 in the rear direction is coupled to a first side end 201 of the rear block 200. A coupler 302 extending from the second side end 102 in the rear direction is coupled to a second side end 202 of the rear block 200. The second side end 202 is positioned on the opposite side from the first side end 201 in the Y-axis direction. It is to be noted that the couplers 300 are not limited to the above-described couplers as long as the front block 100 and the rear block 200 are coupled and the front block 100, the rear block 200, and the couplers 300 are worn on the head of the user.

The rear block 200 includes the first member 210 including the high-temperature part, and the second member 220 attachable to the first member 210. The rear block 200 forms an internal space 280 when the second member 220 is attached to the first member 210. For example, the second member 220 may be attached to the first member 210 so as to seal the internal space 280. Alternatively, the second member 220 may be attached to the first member 210 such that a portion of the internal space 280 communicates with an outside. As illustrated in FIG. 2, the first member 210 has an opening 203. The second member 220 is attached to the opening 203 so as to seal the internal space 280. For example, the second member 220 may have a structure that allows the whole second member 220 to separate from the first member 210 as illustrated in FIG. 2, or may have a structure that allows a portion of the second member 220 to be coupled to the first member 210. With regard to attachment of the second member 220 to the first member 210, for example, the first member 210 and the second member 220 may have structures that allow them to fit each other, or structures that allow them to be screwed with each other. Alternatively, the second member 220 may be screwed to the first member 210, for example. Alternatively, for example, the second member 220 may be partially coupled to the first member 210 by a hinge, and at least a portion of the second member 220 other than the portion coupled by the hinge may be fixed to the first member 210. This makes it possible to close the internal space 280.

As illustrated in FIG. 1, the couplers 300 are respectively coupled to the first side end 201, which is one of the side ends of the rear block 200, and the second side end 202, which is the other side end positioned on the opposite side from the first side end 201 in the Y-axis direction, of the rear block 200.

It is possible to produce the first member 210 through a variety of known methods by using a variety of known materials. For example, the first member 210 may be produced through injection molding by using thermoplastic resin as the material. In the case where the display device 10 is the HMD, the first member 210 constitutes a surface that does not abut on the head of the user in the rear block 200, for example.

The shape of the first member 210 is not limited to the shape exemplified in FIG. 1 to FIG. 3. The first member 210 may have any shape. For example, the first member 210 may have a polygonal shape or arch shape.

It is possible to produce the second member 220 through a variety of known methods by using a variety of known materials. For example, the second member 220 may be produced through injection molding by using thermoplastic resin as the material. In the case where the display device 10 is the HMD, a surface of the second member 220 that abuts on the head of the user may be produced by using a variety of foamed plastics as material. For example, urethane foam, polyolefin foam, polyethylene foam, or the like may be used as material for the production.

As schematically illustrated in FIG. 3, the internal space 280 of the rear block 200 stores a battery 250 for operating the display device 10, and a control board 260 for controlling the operation of the display unit 110. The battery 250 and the control board 260 serve as the high-temperature parts that produce heat while the display device 10 is operating. Therefore, the internal space 280 stores a heat release structure for releasing heat of the high-temperature parts to the outside of the rear block 200. As an example of the heat release structure, the first heat-transfer member 230, the elastic body 240, and a second heat-transfer member 270 are installed in the internal space 280 of the rear block 200. The battery 250 is an example of a first high-temperature part according to the present disclosure, and the control board 260 is an example of a second high-temperature part according to the present disclosure. It is to be noted that the battery 250 and the control board 260 have portions that produce heat at higher temperature than other parts while the display device 10 operates. Alternatively, for example, the high-temperature part may be a part that accumulates ambient heat to be heated to higher temperature than the other parts.

The first heat-transfer member 230 is coupled to the high-temperature parts in a state where the second member 220 is attached to the first member 210 (specifically, the first heat-transfer member 230 is in contact with the battery 250, which is an example of the first high-temperature part, without being fixed). The first heat-transfer member 230 has a function of transferring heat of the high-temperature parts in the internal space 280 to a predetermined position of a casing of the rear block 200 and releasing the heat of the high-temperature parts from the predetermined position to the outside of the rear block 200. In other words, the first heat-transfer member 230 is thermally coupled to the high-temperature parts. In addition, in the present embodiment, the first heat-transfer member 230 is deformable, and the position of the first heat-transfer member 230 may relatively change in the internal space 280. This allows the first heat-transfer member 230 to easily follow deformation of the high-temperature parts even in a case where the high-temperature parts deform over time, for example. Examples of the deformable first heat-transfer member 230 include a sheet member.

For example, it is preferable that lightweight material with high thermal conductivity be used as material for the first heat-transfer member 230. Examples of such lightweight material with high thermal conductivity include carbon-based material, metal material, thermally conductive synthetic resin material, and the like. Specifically, for example, a copper sheet, an aluminum sheet, a graphite sheet, a thermally conductive acrylic sheet, a silicone sheet, or the like may be used as the material for the first heat-transfer member 230. When the lightweight material with high thermal conductivity is used as the material for the first heat-transfer member 230, it is possible to release heat of the high-temperature parts to the outside of the rear block 200 more efficiently while suppressing increase in mass of the rear block 200. It is more preferable that the graphite sheet be used as the material for the first heat-transfer member 230. When the graphite sheet is used as the material for the first heat-transfer member 230, it is possible to design a lightweight display device with good thermal conductivity while reducing its space.

As schematically illustrated in FIG. 2 and FIG. 3, such a first heat-transfer member 230 is attached to a surface of the second member 220 opposed to the internal space 280. For example, the first heat-transfer member 230 is bonded to the surface of the second member 220 opposed to the internal space 280, with a variety of thermally conductive adhesives, for example. An adhesive including a thermally conductive filler may be used as such a thermally conductive adhesive. The thermally conductive filler may be selected from a group including alumina, aluminium nitride, silicon carbide, graphite, and the like, for example.

For example, the first heat-transfer member 230 may have a thickness that allows flexibility to be maintained in such a manner that workability is not deteriorated when attaching the first heat-transfer member 230 to the second member 220. The first heat-transfer member 230 may have a thickness of 0.6 mm or less in a case of a structure in which the second member 220 has a partially stepped surface opposed to the internal space 280 of the first member 210 as illustrated in FIG. 2 and FIG. 3, for example. In a case where a graphite sheet is used as the first heat-transfer member 230, thermal conductivity of the graphite sheet in a thickness direction is smaller than thermal conductivity of the graphite sheet in a surface direction. Therefore, there is a possibility that the heat-transfer efficiency is deteriorated if the graphite sheet has an excessive thickness. Accordingly, for example, in the case of the structure in which the second member 220 has a partially stepped surface opposed to the internal space 280 of the first member 210 as illustrated in FIG. 2 and FIG. 3, a laminated graphite sheet including 15 layers or less, each of which has a thickness of 25 µm, is preferably used as the first heat-transfer member 230. For example, a laminated graphite sheet of approximately 0.6 mm may be obtained by bonding 15 layers of graphite sheets, each of which has the thickness of 25 µm, with flexible adhesive material such as double-sided tape. This laminated graphite sheet has flexibility, and this makes it possible to efficiently attach the laminated graphite sheet to the second member 220.

For example, the first heat-transfer member 230 is installed on at least a portion, facing the battery 250, of the surface of the second member 220 opposed to the internal space 280. As described above, because the second member 220 includes the first heat-transfer member 230, the elastic body 240 allows the first heat-transfer member 230 to be coupled to the battery 250 when the second member 220 is attached to the first member 210. This makes it possible to release heat of the battery 250 from the second member 220 to the outside via the first heat-transfer member 230. At this time, the area of surface in which the first heat-transfer member 230 is coupled to the battery 250 is preferably larger than area of surface in which the elastic body 240 is coupled to the first heat-transfer member 230. When the area of the surface in which the first heat-transfer member 230 is coupled to the battery 250 is larger than the area of the surface in which the elastic body 240 is coupled to the first heat-transfer members 230, it is possible for the first heat-transfer member 230 to efficiently transfer the heat of the battery 250 to the second member 220. The first heat-transfer member 230 is preferably attached to a wide area of the surface of the second member 220 opposed to the internal space 280. As the area of surface in which the first heat-transfer member 230 comes into contact with the second member 220 increases, it becomes possible for the first heat-transfer member 230 to transfer the heat of the battery 250 to the second member 220 more efficiently. This makes it possible to release the heat transferred to the second member 220, from the second member 220 to the outside of the rear block 200 within a shorter time. It is to be noted that, for example, in a case where a surface of the second member 220 adjacent to the internal space 280 includes a part such as a rib or a boss that requires effort to attach the first heat-transfer members 230, the first heat-transfer members 230 may be attached to portions other than such a part.

A plurality of the first heat-transfer members 230 may be attached to the surface of the second member 220 opposed to the internal space 280, for example. For instance, as illustrated in FIG. 2 and FIG. 3, two first heat-transfer members 230 may be attached to the surface of the second member 220 opposed to the internal space 280. The present disclosure is not limited to the embodiment illustrated in FIG. 2 and FIG. 3. Depending on the design of the display device 10, the second member 220 may include the single first heat-transfer member 230, or the three or more first heat-transfer members 230. When the plurality of first heat-transfer members 230 is used, it is possible to easily attach the first heat-transfer members 230 even in a case where the first member 210 has a more complicated structure.

The elastic body 240 is a member having predetermined elasticity, and is installed so as to be in contact with the first heat-transfer member 230. Specifically, when the second member 220 is attached to the first member 210, the elastic body 240 presses the first heat-transfer member 230 with its elasticity, coupling the first heat-transfer member 230 to the battery 250. For example, as illustrated in FIG. 4, it is possible for the elastic body 240 to deform following deformation of the battery 250 in a case where the high-temperature part swells over time and stress is applied from the first heat-transfer member 230 to the elastic body 240 due to the swelling. In addition, the elastic body 240 generates restoring force against the stress applied by the elasticity of the elastic body 240 itself. This allows the elastic body 240 to cause the first heat-transfer member 230 to abut on the high-temperature part by using the generated restoring force. As described above, it is possible for the elastic body 240 to maintain the state where the first heat-transfer member 230 is coupled to the battery 250 while the second member 220 is attached to the first member 210. It is possible to form the elastic body 240 by using known material having elasticity. Examples of such material having elasticity include a variety of foamed plastics. Specific examples of the foamed plastics include urethane foam, polyolefin foam, polyethylene foam, and the like.

The elastic body 240 may be bonded to the second member 220 with adhesive, adhesive tape, or the like. In addition, the elastic body 240 may be bonded to the first heat-transfer member 230 with adhesive, adhesive tape, or the like.

The area of the surface in which the elastic body 240 is in contact with the first heat-transfer member 230 is not specifically limited as long as the elastic body 240 has restoring force that allows the first heat-transfer member 230 to abut on the battery 250. The area of the surface in which the elastic body 240 is in contact with the first heat-transfer member 230 may be the same as the area of a surface in which the battery 250 is in contact with the first heat-transfer member 230, for example.

In addition, the length of the elastic body 240 (in other words, the thickness of elastic body 240) in a direction perpendicular to the surface in which the elastic body 240 is in contact with the first heat-transfer member 230 (X-axis direction) is preferably longer than the amount of change in dimension of the battery 250 obtained when the dimension of the battery 250 changes over time. If the amount of temporal change in dimension of the battery 250 is 1 mm, the length of the elastic body 240 in the direction perpendicular to the surface in which the elastic body 240 is in contact with the first heat-transfer member 230 may be approximately 3 mm, for example. A margin for swelling of the battery 250 may be set to a value equivalent to the length of the elastic body 240 in the direction perpendicular to the surface in which the elastic body 240 is in contact with the first heat-transfer member 230. As a result, this makes it possible to prevent the rear block 200 from getting damaged. For example, this makes it possible to prevent an attachment between the first member 210 and the second member 220 from being damaged due to swelling of the the battery 250.

The battery 250 supplies electric power necessary to operate the display device 10. The battery 250 is disposed in the internal space 280. It is possible to use, as the battery 250, a battery detachable from the display device 10. For example, when detaching the second member 220 from the first member 210, the battery 250 appears from the opening 203, allowing the user to detach the battery 250. Examples of such a battery 250 include an existing primary battery and an existing secondary battery. Specific examples of the battery 250 include an alkaline battery, a silver-oxide battery, a zinc-air battery, a nickel metal hydride battery, a lithium-ion secondary battery, and the like. In addition, the shape of the battery 250 is not specifically limited. For example, the battery 250 may have a polygonal shape, a cylindrical shape, a laminated shape, or the like. Examples of the battery 250 includes a battery that may deform over time. It is to be noted that FIG. 2 and FIG. 3 illustrate the two batteries 250 stored in the internal space 280. However, the number of batteries may be appropriately changed in accordance with specifications of the display device 10.

The control board 260 has a function of controlling an operation of the display device 10. The control board 260 includes a central processing unit (CPU), a memory, an input/output (I/O) unit, a resistor, a coil, a capacitor, or the like that constitute a circuit. Examples of a board constituting the control board 260 include a rigid board that does not have flexibility, and a flexible base that has flexibility. As the rigid board, for example, a paper phenolic board, a glass composite board, a glass epoxy board, or the like may be used. As material for the flexible board, for example, polyimide or polyester may be used.

The control board 260 may be subjected to an insulating process according to a known method. The control board 260 may be subjected to the insulating process by using a method of applying insulating material, for example. Specifically, polyvinyl resin, acrylate resin, urethane resin, or the like may be applied through handpainting, spraying, dipping, potting, or the like.

The control board 260 is fixed in the internal space 280 by using a fixture member installed in the internal space 280. The control board 260 may be disposed in parallel to a YZ-plane as illustrated in FIG. 2 and FIG. 3, for example. However, the shape of the control board 260 is not limited to the shape exemplified in FIG. 2 and FIG. 3. The control board 260 may have any shape.

In addition, in many cases, the amount of heat produced by the control board 260, which is an example of the high-temperature part, is larger than the amount of heat produced by the battery 250. Therefore, the control board 260 is preferably disposed at a position farther away from the opening 203 than the battery 250 in the internal space 280, for example. In the case where the display device 10 is an HMD, the control board 260 is disposed at the above-described position. This makes it possible to dispose the control board 260, which produces higher heat than the battery 250, at a position farther away from the head of the user. Accordingly, it is possible to reduce health damage to the user from the heat produced by the control board 260.

In addition, the high-temperature parts may be disposed depending on possible temperatures of the high-temperature parts. For example, sometimes a high-temperature part with small heat capacity has a higher temperature than a high-temperature part that produces a large amount of heat even in a case where the high-temperature part with small heat capacity produces a small amount of heat. In addition, sometimes a high-temperature part partially has a high temperature depending on a structure or material of the high-temperature part. Therefore, when the high-temperature parts are disposed depending on the possible temperatures reached by the high-temperature parts, it is possible to reduce health damage to the user. For example, a high-temperature part that produces higher heat may be disposed at a position away from the head of the user.

The second heat-transfer member 270 is in contact with a high-temperature part, and has a function of releasing heat of the high-temperature part installed in the internal space 280 to the outside of the rear block 200. In addition, the second heat-transfer member 270 is deformable, and may have a sheet shape. For example, as material for the first heat-transfer member 230, carbon-based material, metal material, thermally conductive synthetic resin material, or the like may be used. Specifically, a graphite sheet, a thermally conductive acrylic sheet, a silicone sheet, or the like may be used.

For example, as illustrated in FIG. 5 and FIG. 6, a portion of the second heat-transfer member 270 is in contact with the control board 260, and another portion of the second heat-transfer member 270 is in contact with an inner surface of the first member 210. Such coupling makes it possible to release heat of the control board 260 from the first member 210 to the outside via the second heat-transfer member 270. The second heat-transfer member 270 may be bonded to the inner surface of the first member 210 with thermally conductive adhesive, for example. An adhesive including a thermally conductive filler may be used as the thermally conductive adhesive. The thermally conductive filler may be selected from a group including alumina, aluminium nitride, silicon carbide, graphite, and the like, for example.

For example, as illustrated in FIG. 5 and FIG. 6, a portion of the second heat-transfer member 270 that is not in contact with the control board 260 or the inner surface of the first member 210 is stored in the internal space 280 in a folded state. For example, as illustrated in FIG. 5, the portion of the second heat-transfer member 270 is folded in such a manner that folding lines of the second heat-transfer member 270 are in parallel to the Y axis. Because the portion of the second heat-transfer member 270 is folded as described above, the second heat-transfer member 270 is disposed in such a manner that the second heat-transfer member 270 is stretchable and shrinkable in the X-axis direction. This makes it possible to easily assemble the first member 210, the control board 260, and the second heat-transfer member 270.

In a case where the second heat-transfer member 270 is electrically conductive, the second heat-transfer member 270 is installed on a non-electrically conductive portion of the control board 260. In addition, in the case where the second heat-transfer member 270 is electrically conductive, an insulated heat-transfer member may be used as the second heat-transfer member 270. If the insulated heat-transfer member is used as the second heat-transfer member 270, it is possible to prevent leakage of current flowing to the control board 260.

In addition, for example, as illustrated in FIG. 6, a surface of the second heat-transfer member 270 that is in contact with the control board 260 may be the same as a surface of the second heat-transfer member 270 that is in contact with the first member 210. In a case where the graphite sheet is used as the second heat-transfer member 270, thermal conductivity of the graphite sheet in the thickness direction is generally higher than thermal conductivity of the graphite sheet in the surface direction. Accordingly, when one of surfaces of the graphite sheet is in contact with both the control board 260 and the first member 210, it is possible to transfer heat of the control board 260 to the first member 210 within a shorter time. This makes it possible to release the heat transferred to the first member 210, from the first member 210 to the outside of the rear block 200 within a shorter time.

The second heat-transfer member 270 is preferably attached to a wide area of the inner surface of the first member 210, for example. As the area of the surface in which the second heat-transfer member 270 is in contact with the first member 210 increases, it becomes possible for the second heat-transfer member 270 to transfer the heat of the control board 260 to the first member 210 more efficiently. This makes it possible to release the heat transferred to the first member 210, from the first member 210 to the outside of the rear block 200 within a shorter time. It is to be noted that, for example, in a case where a part such as a rib or a boss that requires effort to attach the second heat-transfer member 270 is installed on the inner surface of the first member 210, the second heat-transfer member 270 may be attached to portions other than such a part.

The second heat-transfer member 270 may have thickness that allows flexibility to be maintained in such a manner that workability is not deteriorated when attaching the second heat-transfer member 270 to the first member 210. For example, the second heat-transfer member 270 may have a thickness of 0.3 mm or less in a case where the first member 210 is curved toward the positive direction of the X-axis and the second heat-transfer member 270 is attached to the inner surface of the first member 120 as illustrated in FIG. 5. For example, in a case where the graphite sheet is used as the second heat-transfer member, a laminated graphite sheet including no more than five layers, each of which has a thickness of 25 µm, may be preferably used. For example, a laminated graphite sheet of approximately 0.3 mm may be obtained by bonding five layers of graphite sheets, each of which has the thickness of 25 µm, with flexible adhesive material such as double-sided tape. This laminated graphite sheet has flexibility, and this makes it possible to efficiently attach the laminated graphite sheet to the first member 210.

The second heat-transfer member 270 may be in contact with a plurality of high-temperature parts. For example, in a case where a plurality of types of high-temperature parts is stored in the internal space 280, the second heat-transfer member 270 may be coupled to a plurality of high-temperature parts including heating elements that produce relatively larger amounts of heat among the plurality of types of high-temperature parts, and another portion of the second heat-transfer member 270 may be coupled to the first member 210. This makes it possible to release heat of the high-temperature parts that produce large amounts of heat, to the outside from the first member 210 disposed at a position away from the head of the user when the display device 10 is used as the HMD. As a result, it is possible to further reduce health damage to the user from the heat produced by the high-temperature parts.

It is to be noted that, in the case where the display device 10 is used as the HMD, the display device 10 may include a known adjustment mechanism for fitting the display device 10 to the size of the head of the user.

The configuration of the display device 10 according to the present embodiment has been described above. Next, a flow of processes to release heat produced in the display device 10 according to the present embodiment is described.

First, the control board 260 is operated by electric power supplied from the battery 250, and the display unit 110 supported by the front block 100 provides the user with a variety of images. At this time, the battery 250 and the control board 260 store heat. The heat of the battery 250 is transferred to the first heat-transfer member 230 that is in contact with the battery 250. Next, the heat transferred to the first heat-transfer member 230 is further transferred to the second member 220, and is released from the second member 220 to the outside of the rear block 200.

In a case where the battery 250 swells over time, stress is applied from the first heat-transfer member 230 to the elastic body 240 due to the swelled battery 250. In this case, the elastic body 240 generates restoring force against the stress applied to the elastic body 240 due to its elasticity. As a result, it is possible for the elastic body 240 to cause the first heat-transfer member 230 to abut on the battery 250. This makes it possible to efficiently release heat to the outside of the rear block 200 via the first heat-transfer member 230 even in a case where a dimension of the battery 250 is changed over time. Accordingly, for example, it is possible to maintain the temperature of the battery 250 at 60°C or less during an operation of the display device 10.

In addition, the heat of the control board 260 is transferred to the second heat-transfer member 270 in contact with the control board 260. Next, the heat transferred to the second heat-transfer member 270 is further transferred to the first member 210, and is released from the first member 210 to the outside of the rear block 200. Accordingly, for example, it is possible to maintain the temperature of the control board 260 at 85°C or less during an operation of the display device 10.

In many cases, the amount of heat produced by the control board 260 is larger than the amount of heat produced by the battery 250. Therefore, it is possible for the display device 10 according to the present embodiment to release heat of the control board 260 from the first member 210 to a direction different from a direction in which the head of the user is positioned. As a result, it is possible to reduce health damage to the user from the heat produced by an operation of the display device 10.

### [Example]

A display device in which the graphite sheet serving as the first heat-transfer member is attached to the second member and the graphite sheet is contact with the battery by using the elastic body in the rear block, and a display device in which the graphite sheet is not attached were respectively designed, and thermal simulations of the display devices were performed by using a known application. The same battery was used for the both display devices, and the both display devices had the same configuration except the presence or absence of the first heat-transfer member. As a result, it was found that a battery surface temperature of the display device including the graphite sheet in contact with the battery was 6°C colder than a battery surface temperature of the display device in which the graphite sheet is not attached.

As described above, according to the display device of the present embodiment, it is possible to release heat of the high-temperature parts to the outside of the display device via the first heat-transfer member that is not fixed to the high-temperature parts. In addition, it is possible to release the heat of the high-temperature parts to the outside more stably.

### <3. Conclusion>

The details of the preferred embodiments of the present disclosure have been described above with reference to the accompanying drawings, whilst the present technology is not limited to such examples. It is obvious that a person having ordinary skill in the art of the present disclosure may find various alterations or modifications within the scope of the technical idea described in the claims, and it should be understood that these alterations and modifications naturally come under the technical scope of the present disclosure.

Further, the effects described herein are merely illustrative or exemplary, and are not limitative. That is, the technique according to the present disclosure may achieve, in addition to or in place of the above effects, other effects that are obvious to those skilled in the art from the description of the present specification.

It is to be noted that the present technology may also have the following configurations.
(1) A display device including
   a second member that is attachable to a first member including a high-temperature part,
   the second member including
   a first heat-transfer member that is deformable and partially contactable with the high-temperature part and
   an elastic body that allows the first heat-transfer member to abut on the high-temperature part.
(2) The display device according to (1) described above, in which the first member includes at least a first high-temperature part and a second high-temperature part that is different from the first high-temperature part.
(3) The display device according to (2) described above, in which
   the first high-temperature part is detachable, and
   the second high-temperature part is fixed to the first member.
(4) The display device according to (2) described above, in which the first high-temperature part is deformable overtime.
(5) The display device according to any one of (2) to (4) described above, in which area of a surface in which the first heat-transfer member is in contact with the first high-temperature part is larger than area of a surface in which the elastic body is in contact with the first heat-transfer member.
(6) The display device according to any one of (2) to (5) described above, in which
   a space is formed by attaching the second member to the first member, and
   the space stores a second heat-transfer member including a portion coupled to the second high-temperature part and another portion coupled to a space-side surface of the first member.
(7) The display device according to (6) described above, in which heat of the first high-temperature part is mainly released from the second member to an outside via the first heat-transfer member, and heat of the second high-temperature part is mainly released from the first member to an outside via the second heat-transfer member.
(8) The display device according to any one of (2) to (7) described above, in which the first high-temperature part and the second high-temperature part produce heat, and
   an amount of heat produced by the first high-temperature part is less than an amount of heat produced by the second high-temperature part.
(9) The display device according to any one of (2) to (8) described above, in which the display device is to be worn on a head of a user, and the first high-temperature part is positioned closer to the head of the user than the second high-temperature part is.
(10) The display device according to any one of (2) to (9) described above, in which the first high-temperature part is a battery.
(11) The display device according to any one of (2) to (10) described above, in which the second high-temperature part is a control board that controls an operation of the display device.
(12) The display device according to any one of (1) to (11) described above, in which the first heat-transfer member has a sheet shape.
(13) A heat release method including:
   installing a second member that is attachable to a first member including a high-temperature part;
   installing, in the second member,
      a first heat-transfer member that is deformable and partially contactable with the high-temperature part, and
      an elastic body that allows the first heat-transfer member to abut on the high-temperature part; and
   releasing heat of the high-temperature part to an outside.

### Reference Signs List

200: rear block
203: opening
210: first member
220: second member
230: first heat-transfer member
240: elastic body
250: battery
260: control board
270: second heat-transfer member
280: internal space

## Claims

1. A display device comprising
a second member that is attachable to a first member including a high-temperature part,
the second member including
a first heat-transfer member that is deformable and partially contactable with the high-temperature part and
an elastic body that allows the first heat-transfer member to abut on the high-temperature part.

2. The display device according to claim 1, wherein the first member includes at least a first high-temperature part and a second high-temperature part that is different from the first high-temperature part.

3. The display device according to claim 2, wherein
the first high-temperature part is detachable, and
the second high-temperature part is fixed to the first member.

4. The display device according to claim 2, wherein the first high-temperature part is deformable over time.

5. The display device according to claim 2, wherein area of a surface in which the first heat-transfer member is in contact with the first high-temperature part is larger than area of a surface in which the elastic body is in contact with the first heat-transfer member.

6. The display device according to claim 2, wherein
a space is formed by attaching the second member to the first member, and
the space stores a second heat-transfer member including a portion coupled to the second high-temperature part and another portion coupled to a space-side surface of the first member.

7. The display device according to claim 6, wherein heat of the first high-temperature part is mainly released from the second member to an outside via the first heat-transfer member, and heat of the second high-temperature part is mainly released from the first member to an outside via the second heat-transfer member.

8. The display device according to claim 2, wherein
the first high-temperature part and the second high-temperature part produce heat, and
an amount of heat produced by the first high-temperature part is less than an amount of heat produced by the second high-temperature part.

9. The display device according to claim 2, wherein the display device is to be worn on a head of a user, and the first high-temperature part is positioned closer to the head of the user than the second high-temperature part is.

10. The display device according to claim 2, wherein the first high-temperature part comprises a battery.

11. The display device according to claim 2, wherein the second high-temperature part comprises a control board that controls an operation of the display device.

12. The display device according to claim 1, wherein the first heat-transfer member has a sheet shape.

13. A heat release method comprising:
installing a second member that is attachable to a first member including a high-temperature part;
installing, in the second member,
a first heat-transfer member that is deformable and partially contactable with the high-temperature part, and
an elastic body that allows the first heat-transfer member to abut on the high-temperature part; and
releasing heat of the high-temperature part to an outside.
